# EUROPÄISCHE PATENTSCHRIFT

(11) **EP 0 948 062 B1**
(45) Veröffentlichungstag und Bekanntmachung des Hinweises auf die Patenterteilung: **26.07.2006**
(21) Anmeldenummer: 99103885.2
(22) Anmeldetag: 01.03.1999
(51) Int. Cl.: H01L 41/22

(54) **Verfahren zur Bestimmung einer Verteilung von charackteristichen Moduli in einem Erzeugnis aus einem nichtlinearen piezoelektrischen Material**
Method to determine the distribution of characteristic moduli in a product of non-linear piezoelectric material
Méthode pour déterminer la répartition de modules cractéristiques dans un produit en matériau piezoélectrique non linéaire

(30) Priorität: 09.03.1998 DE 19810056
(43) Veröffentlichungstag der Anmeldung: 06.10.1999
(73) Patentinhaber: SIEMENS AKTIENGESELLSCHAFT, 80333 München (DE)
(72) Erfinder: Steinkopff, Thorsten, Dr., 85614 Eglharting (DE)

(56) Entgegenhaltungen:
- WO-A-92/19564
- US-A- 5 336 422
- US-A- 5 686 777
- KAMLAH M ET AL: "Macroscopic description of non-linear electro-mechanical coupling in ferroelectrics" PROCEEDINGS OF THE SPIE - THE INTERNATIONAL SOCIETY FOR OPTICAL ENGINEERING SPIE-INT. SOC. OPT. ENG USA, Bd. 3039, 1997, Seiten 144-155, XP009036768 ISSN: 0277-786X
- LAPSHIN R V: "ANALYTICAL MODEL FOR THE APPROXIMATION OF HYSTERESIS LOOP AND ITS APPLICATION TO THE SCANNING TUNNELING MICROSCOPE" REVIEW OF SCIENTIFIC INSTRUMENTS, AMERICAN INSTITUTE OF PHYSICS. NEW YORK, US, Bd. 66, Nr. 9, 1. September 1995 (1995-09-01), Seiten 4718-4730, XP000528744 ISSN: 0034-6748
- KAGAWA Y ET AL: "Finite element stimulation of two-dimensional electromechanical resonators" IEEE TRANSACTIONS ON SONICS AND ULTRASONICS USA, Bd. SU-21, Nr. 4, Oktober 1974 (1974-10), Seiten 275-283, XP009036779 ISSN: 0018-9537
- OH K-Y ET AL: "Field induced strains in antiferroelectrics" IEEE 1990 ULTRASONICS SYMPOSIUM, 4. Dezember 1990 (1990-12-04), Seiten 743-746, XP010010118

## Beschreibung

Verfahren zur Bestimmung einer Verteilung von charakteristischen Moduli in einem Erzeugnis aus einem nicht linearen piezoeleektrischen Material.

Die Erfindung betrifft ein Verfahren zur Bestimmung einer Verteilung von charakteristischen Moduli in einem Erzeugnis aus einem nicht linearen piezoelektrischen Material, worin eine Vielzahl von Aufpunkten definiert ist und welches einer Verteilung eines elektrischen Feldes aussetzbar ist.

Die Erfindung bezieht sich insbesondere e auf ein Erzeugnis, welches als piezoelektrischer Aktor oder piezoelektrisches Antriebselement eingesetzt werden soll. Ein solches Erzeugnis kommt in Frage als antreibender Bestandteil eines Einspritzventils zur Zuführung.von Kraftstoff zu einem Verbrennungsmotor. Ein Einspritzventil dieser Art ist von besonderem Interesse in einer sog. "Common Rail"-Einspritzanlage für einen Verbrennungsmotor. In dieser Einspritzanlage gibt es ein Reservoir, geläufig als "Common Rail" bezeichnet, worin der Kraftstoff unter hohem Druck bereitgestellt wird. An das Reservoir angeschlossen sind mehrere Einspritzventile, durch die der Kraftstoff zu dem Verbrennungsmotor gelangt.

Ein für eine solche Anwendung in Frage kommendes Material ist eine Keramik aus einem Mischoxid enthaltend Blei, Zirkon und Titan, bekannt unter der Bezeichnung "PZT". Dieses üblicherweise polykristallin texturierte Material zeigt ein ausgeprägt nichtlineares Verhalten hinsichtlich seiner elektrischen und mechanischen Eigenschaften insbesondere dann, wenn die elektrische Feldstärke, der das Material ausgesetzt ist, einen Betrag von 1 kV/mm oder die mechanische Spannung, der das Material ausgesetzt ist, einen Betrag von 25 MPa überschreitet. Dieses Verhalten ist darin begründet, daß das Material unter einer entsprechenden Beanspruchung neben der Piezoelektrizität zusätzlich Ferroelektrizität und Ferroelastizität zeigt. Sowohl Ferroelektrizität als auch Ferroelastizität sind gekennzeichnet durch ausgeprägte Nichtlinearität und auch Hysterese. Mikroskopisch äußern sich Ferroelektrizität bzw. Ferroelastizität dadurch, daß sich in dem Material Bereiche einheitlicher Polarisation oder einheitlicher Dehnung bilden, sog. Domänen. Veränderungen der Beanspruchung bewirken, daß diese Domänen sich vergrößern oder verkleinern. Polarisation und Dehnung in solchen Domänen sind sowohl stark anisotrop als auch streng miteinander gekoppelt, und dies in einer Weise, die sich vom herkömmlichen linearen piezoelektrischen Effekt, welcher an einem eine einzige Domäne aufweisenden Einkristall beobachtet wird, unterscheidet.

Ein wesentlicher Schritt bei der Herstellung eines Erzeugnisses aus einem nichtlinearen piezoelektrischen Material ist die sog. "Polung", bei der das Erzeugnis erstmalig einem elektrischen Feld ausgesetzt wird, welches zu einer Verteilung einer bleibenden Polarisation in dem Material führt und seine piezoelektrische Eigenschaft erst hervorruft. Zu diesem Zweck wird das Erzeugnis einem elektrischen Feld mit einer Feldstärke von üblicherweise etwa 2 kV/mm ausgesetzt, wobei es zu einer Dehnung des Erzeugnisses in Richtung des elektrischen Feldes von üblicherweise 0,3 % kommt. Mikroskopisch betrachtet bewirkt die Polung eine Ausrichtung von Domänen in dem Erzeugnis und ist wesentlich bestimmt durch die Beweglichkeit der einander benachbarte Domänen voneinander trennenden Flächen, der sog. "Wände". Auch das Verhalten des Erzeugnisses im Rahmen des späteren bestimmungsgemäßen Betriebes ist wesentlich beeinflußt durch die Beweglichkeit der Wände. Eine während des Betriebs üblicherweise geforderte Dehnung eines solchen Erzeugnisses liegt in der Größenordnung von 0,15 %. Ist das Erzeugnis inhomogen strukturiert, beispielsweise als Stapel mit inneren Elektroden, deren jede das Erzeugnis nur unvollständig durchquert, so gelingt in der Regel keine homogene Polarisierung des Materials in dem Erzeugnis. Bereiche des Erzeugnisses, die bei der Polung nicht oder nur teilweise von dem elektrischen Feld erfaßt werden (nichtaktive Bereiche) geraten dann, wenn sich die von dem elektrischen Feld erfaßten (aktiven) Bereiche des Erzeugnisses unter dessen Wirkung verlängern, unter mechanische Zugspannung. Dies kann unter Umständen zu Rissen in dem Material führen; entstehen solche Risse bei der Polung, bezeichnet man sie geläufig als "Polungsrisse". Solche Polungsrisse können während des späteren Betriebes des Erzeugnisses wachsen, insbesondere dann, wenn Ermüdungserscheinungen des Materials aufkommen. Auch kann es während des Betriebes zu weiteren Rissen kommen.

Um ein Erzeugnis der eingangs genannten Art unter Sicherstellung einer angemessenen betrieblichen Zuverlässigkeit konstruieren zu können ist es notwendig, das Verhalten des Erzeugnisses unter den zu erwartenden elektrischen und mechanischen Belastungen beschreiben zu können. Eine entsprechende Beschreibung ist auch nützlich als Instrument zur Qualitätssicherung und Qualitätskontrolle sowie zum Funktionsnachweis, wie gefordert von entsprechenden Normen (ISO-9000). Die Beschreibung kann auch ein wertvolles Mittel sein, um den Auskunftsanforderungen auf Seiten der Automobilindustrie hinsichtlich Aufbau, Funktion und Qualität zuzuliefernder Erzeugnisse gerecht zu werden.

Bisher bekannte Verfahren zur Beschreibung eines Erzeugnisses aus einem piezoelektrischen Material sind beschränkt auf solche Bedingungen, bei denen von einem linearen Verhalten des Materials und einem von Ferroelektrizität und Ferroelastizität unbeeinflußten piezoelektrischen Effekt ausgegangen werden kann. Ein solches Verfahren steht beispielsweise zur Verfügung im Rahmen des die Methode der Finiten Elemente anwendenden Softwarepaketes ANSYS, siehe "ANSYS Users Manual for Revision 5.0", Vol.1, Swanson, Analysis Systems, Inc., Houston, Pennsylvania, 1992. Von besonderem Interesse in dieser Veröffentlichung ist das Kapitel 8 "Coupled-Field Analysis", Seiten 8-1 ff. Die Behandlung des piezoelektrischen Effektes ist erläutert im Abschnitt "Piezoelectric Analysis", Seiten 8-11 bis 8-13.

Ein Erzeugnis aus einem piezoelektrischen Material mit inneren Elektroden geht hervor aus dem Artikel "Internal Electrode Piezoelectric Ceramic Actuator", Jap. Journal of Applied Physics 22 (1983) 157. Erwähnt in diesem Artikel ist auch eine Möglichkeit zur Berücksichtigung der in dem Erzeugnis möglicherweise auftretenden Zugspannung, um eine ausreichende betriebliche Zuverlässigkeit des Erzeugnisses sicherzustellen.

Ein Verfahren zur Untersuchung eines linearen piezoelektrischen Materials mit den Methoden der linearen elektroelastischen Bruchmechanik geht hervor aus einem Artikel von Y. E. Pak, International Journal of Fracture 54 (1992) 79. Dieses Verfahren gestattet es, die Umgebung eines Risses in einem linearen piezoelektrischen Material zu beschreiben.

Die DE 44 26 814 C1 beschreibt eine Anordnung zur dynamischen Kraft-Weg-Messung, welche benutzbar ist, um Messungen an einem Erzeugnis der vorliegend betrachteten Art durchzuführen.

Die Aufgabe der Erfindung besteht darin, ein Erzeugnis so zu charakterisieren, daß eine Ermittlung der unter einer vorgegebenen Beanspruchung zu erwartenden Belastung des Erzeugnisses möglich ist. Angegeben wird ein Verfahren zur Charakterisierung eines Erzeugnisses.

Das in Anspruch 1 zur Lösung der Aufgabe angegebene Verfahren zur Bestimmung einer Verteilung von charakteristischen linearen Moduli in einem Erzeugnis aus einem nichtlinearen piezoelektrischen Material, worin eine Vielzahl von Aufpunkten definiert ist und welches einer Verteilung eines elektrischen Feldes aufgesetzt ist, umfaßt:
Bestimmung einer Kennlinienschar, welche Zusammenhänge zwischen dem elektrischen Feld und weiteren Zustandsgrößen in dem Material beschreibt;
für jeden Modul Projektion einer zugegehörigen Kennlinie aus der Kennlinienschar;
an jedem Aufpunkt Bestimmung jedes Moduls als Steigung einer von einem Nullpunkt der zugehörigen Kennlinie bis zu einem dem Aufpunkt entsprechenden Punkt der Kennlinie reichenden Sekante.

Gemäß der Erfindung wird ein Erzeugnis aus einem nichtlinearen piezoelektrischen Material unter der Voraussetzung, daß es einer vorgegebenen Verteilung eines elektrischen Feldes ausgesetzt ist, modelliert als inhomogen strukturiertes Erzeugnis aus sich linear verhaltendem Material. Man ermittelt an jedem Aufpunkt die unter dem vorgegebenen elektrischen Feld herrschenden Zustandsgrößen und macht weiter die modellhafte Annahme, daß diese Zustandsgrößen im Rahmen linearer Prozesse erreicht werden. Ein solcher linearer Prozeß wird beschrieben durch eine Sekante in der zugehörigen Kennlinie. Es wird somit eine Verteilung charakteristischer linearer Moduli in dem Erzeugnis angegeben, welche das nichtlineare piezoelektrische und ggf. von Ferroelektrizität oder Ferroelastizität modifizierte Verhalten des Erzeugnisses richtig beschreibt. Diese Verteilung kann verwendet werden als Eingabe für ein herkömmliches lineares Rechenverfahren wie enthalten im genannten Softwarepaket ANSYS, um das Verhalten des Erzeugnisses unter der von dem elektrischen Feld sowie eventuell vorhandener zusätzlicher Belastung zu ermitteln und insbesondere die Verteilung mechanischer Spannung in dem Erzeugnis zutreffend zu beschreiben.

Jeder charakteristische lineare Modul wird ermittelt als Steigung einer Sekante, die in einer zugehörigen Kennlinie von einem Nullpunkt bis zu einem dem betrachteten Aufpunkt entsprechenden Punkt der Kennlinie reicht. Der dem Aufpunkt entsprechende Punkt der Kennlinie ist der dem elektrischen Feld bzw. einer anderen maßgeblichen, vorher ermittelten Zustandsgröße des Erzeugnisses im betrachteten Aufpunkt entsprechende Punkt der Kennlinie. Mithin gibt der charakteristische lineare Modul die Verhältnisse am Aufpunkt weitgehend richtig wieder, soweit sich diese Verhältnisse aufgrund einer bis dahin noch nicht berücksichtigten Dehnung oder mechanischen Spannung nicht allzu stark verändern. Es kann somit davon ausgegangen werden, daß das im Rahmen der Erfindung zum Einsatz kommende lineare Modell das Erzeugnis weitgehend richtig beschreibt.

Die weiteren Zustandsgrößen, die in dem Erzeugnis oder für die Durchführung des Verfahrens maßgeblich sind, sind vorzugsweise spezifiziert als Dehnung, mechanische Spannung und Polarisation. Diese drei genannten Zustandsgrößen bilden mit dem vorgegebenen elektrischen Feld einen Satz von Zustandsgrößen, welcher die piezoelektrischen, ferroelektrischen und ferroelastischen Eigenschaften des Materials vollständig bestimmt. In diesem Zusammenhang werden die charakteristischen linearen Moduli mit weiterem Vorzug so gewählt, daß sie einen linearisierten Zusammenhang zwischen elektrischem Feld und Dehnung bei vorgegebener mechanischer Spannung, zwischen elektrischem Feld und Polarisation bei vorgegebener mechanischer Spannung oder zwischen Dehnung und mechanischer Spannung bei vorgegebenem elektrischem Feld beschreiben. Diese Wahl entspricht weitgehend geläufiger Praxis im Rahmen der üblichen Beschreibung der Piezoelektrizität.

Im Rahmen einer Weiterbildung ist in dem Erzeugnis ein erster Bereich vorgesehen, in welchem das elektrische Feld wesentlich verschieden von Null ist, sowie ein zweiter Bereich, in welchem das elektrische Feld im wesentlichen gleich Null ist, und es wird die mechanische Spannung in dem Erzeugnis an jedem Aufpunkt im ersten Bereich gleich Null angenommen. Ein solches Erzeugnis ist beispielsweise ein piezoelektrischer Aktor mit inneren, das Erzeugnis nicht ganz durchquerenden Elektroden. Bei einem solchen Aktor gelingt normalerweise keine homogene Polarisation des piezoelektrischen Materials bei der Polung, und es verbleibt zumindest ein piezoelektrisch inaktiver Bereich. Wenn das Erzeugnis einem elektrischen Feld ausgesetzt wird, sei es dem zur Polung notwendigen elektrischen Feld oder einem elektrischen Feld während seines bestimmungsgemäßen Betriebs, so wird sich jeder piezoelektrisch aktivierte Bereich des Erzeugnisses dehnen, ohne daß es dabei zu wesentlichen mechanischen Spannungen innerhalb dieses Bereiches kommt. Ein piezoelektrisch inaktiver Bereich wird von dem elektrischen Feld nicht beeinflußt, gerät aber unter mechanische Spannung, und zwar mechanischen Zug, aufgrund der Verformung des Erzeugnisses durch die piezoelektrisch hervorgerufene Dehnung im piezoelektrisch aktiven Bereich. In dieser Situation ist es möglich und sinnvoll, von einer verschwindenden mechanischen Spannung in jedem piezoelektrisch aktiven Bereich auszugehen, und ein solcher Bereich ist regelmäßig dadurch ausgezeichnet, daß das elektrische Feld in ihm wesentlich verschieden von Null ist. Wesentlich von Null verschiedene mechanische Spannung tritt nur dort auf, wo keine Polarisation des Materials vorliegt, also wo es keine wesentlich von Null verschiedene Stärke des elektrischen Feldes gibt. Die entsprechende Aufteilung erleichtert die Charakterisierung des Erzeugnisses wesentlich, denn sie erlaubt es auszugehen von der Alternative, daß an einem betrachteten Aufpunkt entweder ein von Null verschiedenes elektrisches Feld bei verschwindender mechanischer Spannung oder ein verschwindendes elektrisches Feld bei von Null verschiedener mechanischer Spannung vorhanden ist.

Das das Erzeugnis belastende elektrische Feld wird mit besonderem Vorzug angesetzt als dasjenige Feld, welches notwendig ist für die Polung des Erzeugnisses. Bei der Belastung des Erzeugnisses mit diesem Feld kommt es geläufig zu einer maximalen mechanischen Beanspruchung. Zur praxisgerechten Konstruktion eines entsprechenden Erzeugnisses ist dieser Fall daher von besonderem Interesse.

Es versteht sich, daß die vorstehenden Erwägungen betreffend vorteilhafte Weiterbildungen des Erzeugnisses oder des Verfahrens analog anwendbar sind auf eine Situation, bei der das Erzeugnis neben dem elektrischen Feld einer zusätzlichen mechanischen Spannung unterworfen ist. Diese Situation ist beispielsweise dann gegeben, wenn das Erzeugnis zum Zwecke der Polung einer zusätzlichen komprimierenden mechanischen Spannung unterworfen wird; diese zusätzliche mechanische Spannung dient insbesondere dazu, eine unerwünscht hohe Dehnung während der Polung zu verhindern.

Das Erzeugnis ist insbesondere ein piezoelektrischer Aktor, wie bereits angedeutet.

Weiterhin vorzugsweise weist das Erzeugnis Elektroden auf, mittels derer es dem elektrischen Feld aussetzbar ist. Solche Elektroden bestehen üblicherweise aus Metall und sind nicht piezoelekrisch; es bestehen grundsätzlich keine Bedenken, die Elektroden einzubeziehen in ein Rechenverfahren, beispielsweise nach der Methode der Finiten Elemente, zur Ermittlung des Verhaltens des Erzeugnisses unter einer spezifischen Belastung.

Mit besonderem Vorzug wird man das elektrische Feld, dem das Erzeugnis ausgesetzt sein soll, so bemessen, daß es einer maximalen Belastung des Erzeugnisses entspricht. Derart kann im Rahmen der Berechnung des Verhaltens des Erzeugnisses die Verteilung der mechanischen Belastungen im Inneren des Erzeugnisses bestimmt werden, und das Erkennen eines besonders hoch belasteten Bereiches in dem Erzeugnis ist zuverlässig möglich.

Das Verfahren im Sinne vorstehender Ausführungen wird mit besonderem Vorzug dahingehend ergänzt, daß nach der Bestimmung der Verteilung der Moduli eine Ermittlung der Zustandsgrößen in dem Material an den Aufpunkten erfolgt mittels eines linearen Modells unter Benutzung der Moduli. Dieses lineare Modell ist insbesondere ein Modell im Sinne der Methode der Finiten Elemente, wie erwähnt.

Ausführungsbeispiele der Erfindung werden nachfolgend anhand der Zeichnung erläutert. Die Zeichnung ist zur Verdeutlichung bestimmter Maßnahmen generell als Schema zu verstehen. Im einzelnen zeigen:
- Figur 1: einen Schnitt durch ein Erzeugnis aus einem nichtlinearen piezoelektrischen Material;
- Figur 2,: Figur 3 und Figur 4 jeweils eine Kennlinie, welche Zusammenhänge zwischen charakteristischen Belastungen eines nichtlinearen piezoelektrischen Materials darstellt;und
- Figur 5: eine weitere solche Kennlinie.

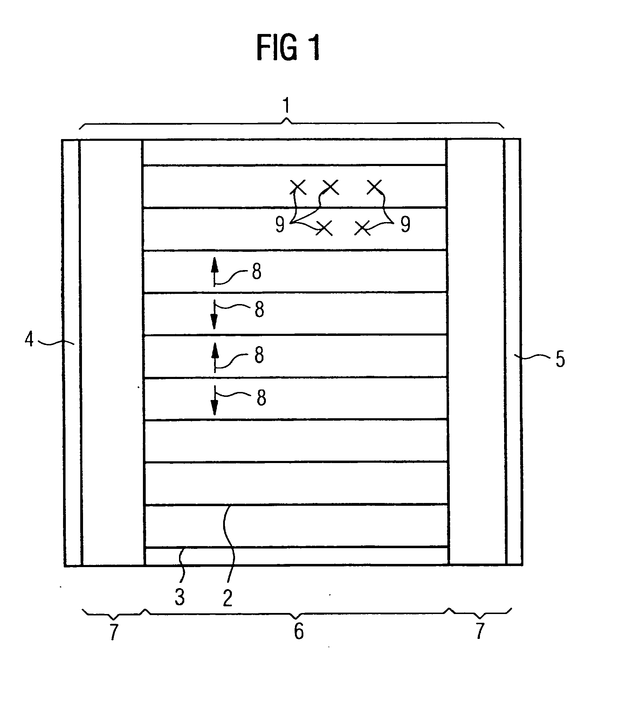

Figur 1 zeigt einen piezoelektrischen Aktor, umfassend ein nichtlineares piezoelektrisches Material 1 bzw. ein Erzeugnis daraus. In das Material 1 eingebettet sind abwechselnd erste innere Elektroden 2 und zweite innere Elektroden 3, bestehend jeweils aus einem gut leitfähigen Material. Alle ersten inneren Elektroden 2 sind kontaktiert an eine erste äußere Elektrode 4; ebenso sind alle zweiten inneren Elektroden 3 kontaktiert an eine einzige zweite äußere Elektrode 5. Zum Betreiben des Aktors wird zwischen die erste äußere Elektrode 4 und die zweite äußere Elektrode 5 eine elektrische Spannung angelegt, welche über die inneren Elektroden 2 und 3 in das Material 1 übertragen wird. Ein erster oder aktiver Bereich 6 in dem Aktor ist definiert durch denjenigen Bereich, in dem erste innere Elektroden 2 und zweite innere Elektroden 3 abwechselnd übereinander angeordnet sind; der aktive Bereich 6 ist benachbart von zwei zweiten oder inaktiven Bereichen 7, welche direkt an jeweils eine äußere Elektrode 4 oder 5 anschließen und in denen es jeweils nur erste innere Elektroden 2 oder zweite innere Elektroden 3 gibt. Im aktiven Bereich 6 entsteht durch die angelegte elektrische Spannung ein elektrisches Feld 8, dessen Verteilung durch Pfeile angedeutet ist. Dieses elektrische Feld 8 wird benutzt, um in dem Aktor den piezoelektrischen Effekt hervorzurufen. In keinem inaktiven Bereich 7 gibt es ein elektrisches Feld wesentlicher Höhe, abgesehen von eventuellen Randeffekten am Übergang zwischen dem inaktiven Bereich 7 und dem aktiven Bereich 6.

Solange das elektrische Feld 8 hinreichend klein bleibt, zeigt der piezoelektrische Effekt ein lineares Verhalten. Unter der Voraussetzung, daß der Aktor mechanisch völlig entlastet, also keinerlei mechanischer Spannung ausgesetzt ist, ergibt sich eine lineare Abhängigkeit zwischen der Stärke des elektrischen Feldes 8 und der Größe der durch dieses hervorgerufenen Dehnung des Materials 1. Wenn aber, wie vorliegend maßgeblich, das elektrische Feld 8 eine gewisse Stärke überschreitet, womit bei einer Anwendung des Aktors in einem Einspritzventil für einen Dieselmotor zu rechnen ist, zeigt der piezoelektrische Effekt ein ausgesprochen nichtlineares Verhalten, ja sogar Hysterese. Zusätzlich treten in dem Material 1 Ferroelektrizität und Ferroelastizität auf.

Ein solches Verhalten des Materials 1 bzw. eines daraus gebildeten Erzeugnisses ist in der Regel nicht mehr im Rahmen einer geschlossenen Theorie behandelbar, sondern erfordert den Einsatz einer numerischen Methode. Besonders geeignet ist die Methode der Finiten Elemente. Diese erfordert es, in dem zu betrachtenden Material eine Vielzahl von mehr oder weniger gleichmäßig verteilten Aufpunkten 9 vorzusehen und die Verhältnisse in dem Erzeugnis derart zu modellieren, daß nur die Verhältnisse auf den Aufpunkten 9 betrachtet werden. Diese Methode eignet sich ideal zur Realisierung auf einem programmgesteuerten Rechner. Sie ist in der Technik weit verbreitet und bedarf an dieser Stelle keiner detaillierten Erläuterung. In Figur 1 eingetragen sind nur wenige solcher Aufpunkte 9, um die Aussagekraft der Figur zu wahren.

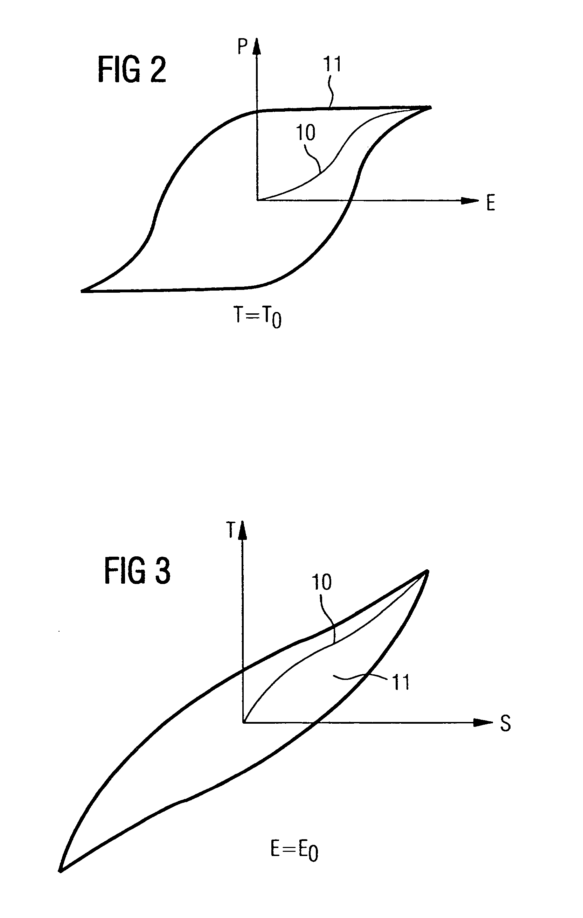

Die Figuren 2, 3 und 4 zeigen, wie die das entsprechende Erzeugnis beschreibenden Größen elektrisches Feld E, Polarisation P, mechanische Spannung T und Dehnung S miteinander zusammenhängen.

Figur 2 zeigt eine Kennlinie der Abhängigkeit der Polarisation P vom elektrischen Feld E. Unter der Polarisation P ist dabei ein Grad einer Ausrichtung elementarer elektrischer Dipole in dem Material 1 zu verstehen. Die elektrischen Dipole ergeben sich aufgrund einer inhomogenen Ladungsverteilung innerhalb der Kristallstruktur des Materials 1. Die Abhängigkeit der Polarisation P vom elektrischen Feld E ist relativ komplex. Ausgehend von einem unpolarisierten, keinerlei elektrischem Feld E ausgesetzten Material ergibt sich bei einer Vergrößerung des elektrischen Feldes E zunächst eine Abhängigkeit gemäß einer sogenannten Neukurve 10, bisweilen auch "jungfräuliche Kurve" genannt. Bei hinreichend großem elektrischen Feld E bleibt die Polarisation P im wesentlichen konstant und wird zunächst auch nicht wesentlich reduziert, wenn das elektrische Feld E wieder verkleinert wird. Eine wesentliche Veränderung der Polarisation P tritt erst ein, wenn das elektrische Feld E umgepolt wurde und bereits wieder eine beachtliche Stärke erreicht hat. Die entsprechende Abhängigkeit wird beschrieben durch eine sogenannte Hysteresekurve 11. Es versteht sich, daß der Zusammenhang zwischen elektrischem Feld E und Polarisation P abhängig ist davon, ob das betrachtete Material 1 zusätzlich einer mechanischen Spannung, sei es einer (mit positivem Vorzeichen anzusetzenden) mechanischen Spannung durch Druck oder einer (mit negativem Vorzeichen anzusetzenden) mechanischen Spannung durch Zug. In diesem Sinne ist einem für alle drei Parameter E, P und T maßgeblichen Kennfeld einer vorgegebenen mechanischen Spannung T₀ entsprechende Kennlinie für den Zusammenhang zwischen E und P zu entnehmen. Der sich in Figur 2 darstellende und durch die aufgezeigte Hysterese gekennzeichnete Effekt ist der sogenannte "ferroelektrische Effekt".

Figur 3 stellt für ein vorgegebenes elektrisches Feld E₀ einen Zusammenhang zwischen Dehnung S und mechanischer Spannung T dar. Dieser Zusammenhang entspricht bei hinreichend geringer Dehnung S dem bekannten Hookeschen Gesetz. Dieses ist bei hinreichend großer Dehnung S allerdings nicht mehr anwendbar und weicht wiederum einem komplexen und durch Hysterese gekennzeichneten Zusammenhang, wie er aus Figur 3 erkennbar ist. Dargestellt sind wiederum eine Neukurve 10 und eine Hysteresekurve 11. Der in Figur 3 aufgezeigte Effekt ist der "ferroelastische Effekt".

Die mikroskopische Deutung der Ferroelektrizität und der Ferroelastizität entspricht der mikroskopischen Deutung des Ferromagnetismus. In dem betrachteten Material bilden sich Domänen aus, in deren jeder die betrachtete Meßgröße konstant ist. Ein makroskopisch maßgeblicher Wert der betrachteten Größe ergibt sich durch Mittelung über alle in Betracht zu ziehenden Domänen. Eine Veränderung der makroskopischen Größe ergibt sich dadurch, daß sich Domänen vergrößern oder verkleinern. Man beschreibt dies bildhaft vielfach derart, daß Wände, welche benachbarte Domänen voneinander trennen, durch das Material wandern.

Vorliegend ist davon auszugehen, daß Ferroelektrizität und Ferroelastizität streng miteinander gekoppelt sind, was sich darin ausdrückt, daß für beide Effekte dieselben Domänen im Material wirksam sind.

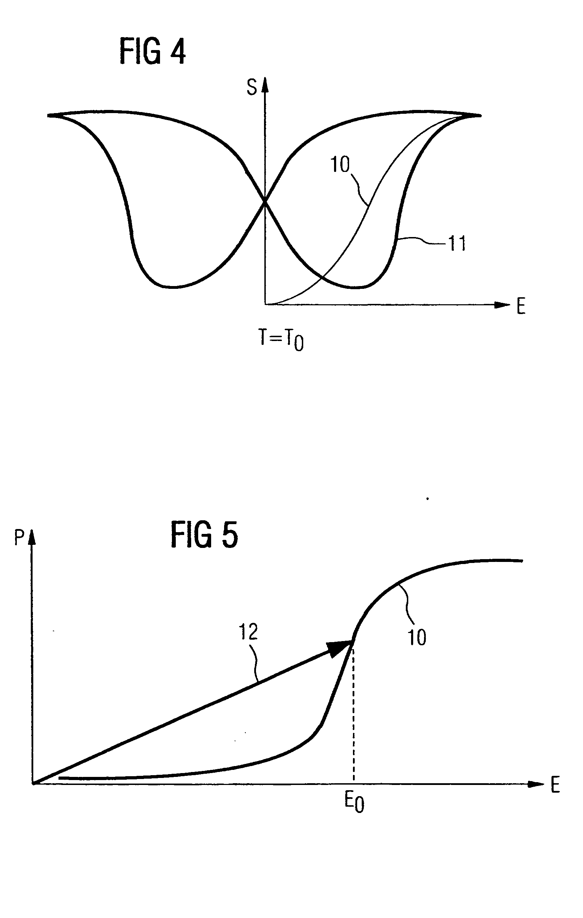

Figur 4 zeigt unter der Voraussetzung vorgegebener mechanischer Spannung T₀ des Materials 1 den Zusammenhang zwischen elektrischem Feld E und Dehnung S, entsprechend dem eigentlichen piezoelektrischen Effekt. Figur 4 zeigt die ausgeprägte Nichtlinearität und Hysterese des piezoelektrischen Effektes, wenn eine relativ große elektrische Feldstärke E in Betracht gezogen wird. Die entsprechende Kennlinie zeigt wiederum eine Neukurve 10 und eine Hysteresekurve 11, die in diesem Fall die Gestalt eines Schmetterlings hat.

Die Figuren 2, 3 und 4 mögen genügen als Anzeichen dafür, daß eine geschlossene theoretische Behandlung eines Erzeugnisses aus einem piezoelektrischen Material 1 wie dargestellt in Figur 1 bislang nicht gelungen ist. Eine solche Behandlung ist insbesondere nicht gelungen im Rahmen der geläufigen Methode der Finiten Elemente, da diese zwar ein relativ komplex aufgebautes Erzeugnis beschreiben kann, jedoch beschränkt auf die Annahme, daß alle im Erzeugnis in Betracht zu ziehenden Effekte linearer Natur sind.

Eine Charakterisierung des Erzeugnisses, welche die Grundlage zur Durchführung von Berechnungen im Rahmen der Methode der Finiten Elemente sein kann, kann allerdings gelingen unter folgender, an Figur 5 illustrierter Annahme: In dem zu betrachtenden Erzeugnis (s. Figur 1) wird zunächst für jeden Aufpunkt 9 das maßgebliche elektrische Feld 8 bestimmt. Dann kann, unter Zuhilfenahme der Neukurve 10 zur Beschreibung des Zusammenhangs zwischen Polarisation P und elektrischem Feld E, die zu dem am betrachteten Aufpunkt 9 herrschenden elektrischen Feld Eo gehörige Polarisation bestimmt werden; sie ergibt sich aus dem zu dem elektrischen Feld E₀ gehörigen Punkt der Neukurve 10. Anschließend wird eine Sekante 12 vom Ursprung des Diagramms zu dem besagten Punkt gezogen, und es wird eine Steigung der Sekante 12 als zu dem Aufpunkt 9 gehöriger charakteristischer linearer Modul für die Beschreibung eines angenommenen linearen Zusammenhangs zwischen elektrischem Feld E und Polarisation P angesetzt. Dies erfolgt für jeden Aufpunkt 9 gesondert, und so wird für jeden Aufpunkt 9 ein zugehöriger charakteristischer linearer Modul erhalten. Dann werden weitere charakteristische Moduli für alle Aufpunkte 9 gewonnen für Zusammenhänge zwischen mechanischer Spannung und Dehnung, s. Figur 3, und Dehnung S und elektrischem Feld E, s. Figur 4. Schließlich liegt für jeden Aufpunkt ein Satz zugehöriger charakteristischer linearer Moduli vor, welcher geeignet ist, das Verhalten des Erzeugnisses unter Belastung mit dem vorgegebenen elektrischen Feld richtig zu beschreiben. Auf dieser Grundlage kann dann eine detaillierte Berechnung des Verhaltens des Erzeugnisses erfolgen unter Benutzung der herkömmlichen Methode der Finiten Elemente, wobei die ermittelten charakteristischen linearen Moduli als Eingangsgrößen dienen.

Bezuggenommen wird schließlich auf frühere Ausführungen zu Weiterbildungen der beschriebenen Charakterisierung unter bestimmten Annahmen, wobei sich die Charakterisierung wesentlich vereinfachen kann. Diese Ausführungen sind hier unvermindert gültig.

Die Erfindung ermöglicht es das Verhalteneines eines Erzeugnisses aus einem nichtlinearen piezoelektrischen Material, welchem eine bestimmte Charakterisierung mittels charakteristischer linearer Moduli beigeordnet ist unter vorgegebener Beanspruchung mit herkömmlichen Mitteln, insbesondere der Methode der Finiten Elemente zu beschreiben. Insbesondere ist es so möglich, die Erfüllung vorgegebener Belastungskriterien durch das Erzeugnis zu verifizieren.

## Patentansprüche

1. Verfahren zur Bestimmung einer Verteilung von charakteristischen linearen Moduli in einem Erzeugnis aus einem nichtlinearen piezoelektrischen Material (1), worin eine Vielzahl von Aufpunkten (9) definiert ist und welches einer Verteilung eines elektrischen Feldes (8) ausgesetzt ist, umfassend:
Bestimmung einer Kennlinienschar, welche Zusammenhänge zwischen dem elektrischen Feld (8) und weiteren Zustandsgrößen in dem Material (1) beschreibt;
für jeden Modul Projektion einer zugehörigen Kennlinie (10) aus der Kennlinienschar; **dadurch gekennzeichnet, dass**
an jedem Aufpunkt (9) eine Bestimmung jedes Moduls als Steigung einer von einem Nullpunkt der zugehörigen Kennlinie (10) bis zu einem dem Aufpunkt entsprechenden Punkt der Kennlinie (10) reichenden Sekante (12) durchgeführt wird.

2. Verfahren nach Anspruch 1, bei dem für jede Kennlinie (10) eine Neukurve (10) verwendet wird.

3. Verfahren nach einem der Ansprüche 1 und 2, bei dem die charakteristischen Belastungen Dehnung, mechanische Spannung und Polarisation sind.

4. Verfahren nach Anspruch 3, bei dem jeder Modul einen linearisierten Zusammenhang zwischen elektrischem Feld (8) und Dehnung bei vorgegebener mechanischer Spannung, zwischen elektrischem Feld (8) und Polarisation bei vorgegebener mechanischer Spannung oder zwischen Dehnung und mechanischer Spannung bei vorgegebenem elektrischem Feld (8) beschreibt.

5. Verfahren nach einem der Ansprüche 1 bis 4, bei dem das elektrische Feld (8) bestimmt wird für eine Situation, bei der das Erzeugnis einer Polung unterzogen wird.

6. Verfahren nach einem der Ansprüche 1 bis 5, bei dem das elektrische Feld (8) bestimmt wird für eine Situation, bei der das Erzeugnis einer zusätzlichen mechanischen Spannung unterworfen ist.

7. Verfahren nach einem der Ansprüche 1 bis 6, bei dem das elektrische Feld (8) so bemessen ist, daß es einer maximalen Belastung des Erzeugnisses entspricht.

8. Verfahren nach einem der Ansprüche 1 bis 7, bei dem nach der Bestimmung der Verteilung der Moduli eine Ermittlung der Zustandsgrößen in dem Material (1) an den Aufpunkten (9) erfolgt mittels eines linearen Modells unter Benutzung der Moduli.

9. Verfahren nach einem der Ansprüche 1 bis 8, bei dem als Erzeugnis ein piezoelektrischer Aktor verwendet wird.

## Claims

1. Method for determining a distribution of characteristic linear moduli in a product made of a non-linear piezoelectric material (1) in which a plurality of reference points (9) are defined, and which is exposed to a distribution of an electrical field (8), comprising:
determining a set of characteristic curves that describes relationships between the electrical field (8) and further state variables in the material (1);
projecting an associated characteristic curve (10) from the set of characteristic curves for each modulus,
**characterised in that**
each modulus is defined at each reference point (9) as the slope of a secant (12) extending from a zero point of the associated characteristic curve (10) to a point of the characteristic curve (10) corresponding to the reference point.

2. Method according to claim 1, wherein a new curve (10) is used for each characteristic curve (10).

3. Method according to one of claims 1 and 2, wherein the characteristic loadings are expansion, mechanical tension and polarisation.

4. Method according to claim 3, wherein each modulus describes a linearised relationship between the electrical field (8) and expansion with a predetermined mechanical tension, between the electrical field (8) and polarisation with a predetermined mechanical tension or between expansion and mechanical tension with a predetermined electrical field (8).

5. Method according to one of claims 1 to 4, wherein the electrical field (8) is determined for a situation in which the product is subjected to poling.

6. Method according to one of claims 1 to 5, wherein the electrical field (8) is determined for a situation in which the product is subjected to an additional mechanical tension.

7. Method according to one of claims 1 to 6, wherein the electrical field (8) is dimensioned such that it corresponds to a maximum loading of the product.

8. Method according to one of claims 1 to 7, wherein, after determining the distribution of the moduli, the state variables in the material (1) are determined at the reference points (9) by means of a linear model using the moduli.

9. Method according to one of claims 1 to 8, wherein a piezoelectric actuator is used as the product.

## Revendications

1. Procédé pour la détermination d'une distribution de moduli linéaires caractéristiques dans un produit fait d'une matière piézoélectrique non linéaire (1), dans lequel une pluralité de points repérés (9) sont définis et qui est exposée à une distribution d'un champ électrique (8), comprenant :
la détermination d'une famille de courbes caractéristiques qui décrit des relations entre le champ électrique (8) et d'autres grandeurs d'état observées dans la matière (1) ;
pour chaque module, la projection d'une courbe caractéristique correspondante (10) prise dans la famille de courbes caractéristiques ; **caractérisé en ce que**, sur chaque point repéré (9), on exécute une détermination de chaque module sous la forme de la pente d'une sécante (12) s'étendant d'un point zéro de la courbe caractéristique correspondante (10) jusqu'à un point de la courbe caractéristique (10) qui correspond au point repéré.

2. Procédé selon la revendication 1, dans lequel on utilise une nouvelle courbe (10) pour chaque courbe caractéristique (10).

3. Procédé selon une des revendications 1 et 2, dans lequel les sollicitations caractéristiques sont la dilatation, la contrainte mécanique et la polarisation.

4. Procédé selon la revendication 3, dans lequel chaque module décrit une relation linéarisée entre le champ électrique (8) et la dilatation en présence d'une contrainte mécanique prédéterminée, entre le champ électrique (8) et la polarisation en présence d'une contrainte mécanique prédéterminée ou entre la dilatation et la contrainte mécanique en présence d'un champ électrique prédéterminé (8).

5. Procédé selon une des revendications 1 à 4, dans lequel le champ électrique (8) est déterminé pour une situation dans laquelle le produit est soumis à une polarisation.

6. Procédé selon une des revendications 1 à 5, dans lequel le champ électrique (8) est déterminé pour une situation dans laquelle le produit est soumis à une contrainte mécanique additionnelle.

7. Procédé selon une des revendications 1 à 6, dans lequel le champ électrique (8) est calculé de manière à correspondre à une sollicitation maximale du produit.

8. Procédé selon une des revendications 1 à 7, dans lequel, après la détermination de la distribution des moduli, on procède à la détermination des grandeurs d'état dans la matière (1) aux points repérés (9) au moyen d'un modèle linéaire et en utilisant les moduli.

9. Procédé selon une des revendications 1 à 8, dans lequel on utilise comme produit un actionneur piézoélectrique.
